(19)

Europäisches Patentamt

European Patent Office

Office européen des brevets

(11)  **EP 4 394 505 A1**

(12)  # EUROPEAN PATENT APPLICATION
published in accordance with Art. 153(4) EPC

(43)  Date of publication:
**03.07.2024  Bulletin 2024/27**

(21)  Application number: **22897238.6**

(22)  Date of filing: **19.08.2022**

(51)  International Patent Classification (IPC):
*G03F 7/00* (2006.01)

(52)  Cooperative Patent Classification (CPC):
**G03F 7/00**

(86)  International application number:
**PCT/CN2022/113515**

(87)  International publication number:
**WO 2023/093143 (01.06.2023 Gazette 2023/22)**

(84)  Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30)  Priority:  **23.11.2021  CN 202111398184**

(71)  Applicant: **Goertek Optical Technology Co., Ltd.
Weifang, Shandong 261031 (CN)**

(72)  Inventors:
• **CAI, Lu**
  **Weifang, Shandong 261031 (CN)**

• **WANG, Weixiang**
  **Weifang, Shandong 261031 (CN)**
• **LI, Ying**
  **Weifang, Shandong 261031 (CN)**
• **ZHANG, Yuliang**
  **Weifang, Shandong 261031 (CN)**
• **HAN, Xingjun**
  **Weifang, Shandong 261031 (CN)**
• **GUO, Peiliang**
  **Weifang, Shandong 261031 (CN)**
• **RAO, Yi**
  **Weifang, Shandong 261031 (CN)**

(74)  Representative: **Winter, Brandl - Partnerschaft mbB
Alois-Steinecker-Straße 22
85354 Freising (DE)**

(54)  **IMPRINTING MOTHER-TEMPLATE AND MANUFACTURING METHOD THEREFOR**

(57)  Disclosed are an imprinting master-template and a manufacturing method therefor, wherein the method includes a master-template and a cushioning structure. A surface of the master-template is provided with a structural area and a non-structural area, the non-structural area being provided on a lateral edge of the structural area, and the structural area being provided with a structural member. The cushioning structure is provided in the non-structural area, when the imprinting master-template is transferred to form the transferring structure for the flexible template, the cushioning structure is used to be imprinted to form a supporting structure that supports the flexible template. The technical solution of the present disclosure reduces occurrence of imprinting voids and improves the yield of nanoimprinting. (Fig. 2)

FIG. 2

**Description**

**TECHNICAL FIELD**

The present disclosure relates to the field of nanoimprinting technologies, and in particular to an imprinting master-template and a manufacturing method therefor.

**BACKGROUND**

A nanoimprinting process is a micro-nano manufacturing process that transfers patterns to substrates with the assistance of nanoimprinting glue, where a master-template is the foundation of the nanoimprinting process. However, the height of a non-structural area of the master-template is usually identical to that of the structural area thereof, and this causes voids to occur at the edge of the structural area during pattern transfer using flexible materials. Such voids cannot be completely filled using the imprinting glue, thereby causing a recessed nanoimprinting defect and reducing the yield of nanoimprinting.

**SUMMARY**

Based on the above, in view of the current problem that during pattern transfer using flexible materials, the yield of nanoimprinting being reduced due to voids that cannot be fully filled using the imprinting glue being formed on a lateral edge of the corresponding structural area, it is necessary to provide an imprinting master-template and a manufacturing method therefor, in order to reduce the occurrence of voids and improve the yield of nanoimprinting.

In order to achieve the above objectives, the present disclosure proposes an imprinting master-template, which includes:

A master-template, a surface of which being provided with a structural area and a non-structural area, the non-structural area being provided on a lateral edge of the structural area, and the structural area being provided with a structural member; and

A cushioning structure, provided in the non-structural area.

In an embodiment of the present disclosure, the cushioning structure comprises grooves provided on two opposite sides of the structural area.

In an embodiment of the present disclosure, the cushioning structure further comprises a plurality of cushioning members arranged spaced apart in the grooves.

In an embodiment of the present disclosure, the plurality of cushioning members are in periodical distribution in the grooves.

In an embodiment of the present disclosure, a direction from a bottom surface of a groove to a mouth of the groove is defined as a height direction, and the cushioning structure comprises a gradual cushioning member whose height decreases from the non-structural area to the structural area.

In an embodiment of the present disclosure, the cushioning structure further comprises a plurality of separators arranged spaced apart on a surface of the gradual cushioning member.

In an embodiment of the present disclosure, the separators are in periodical distribution in the grooves.

In an embodiment of the present disclosure, periodic distribution of the cushioning members comprises extension in a length direction thereof and spaced-apart arrangement in both the length direction and a width direction thereof.

In an embodiment of the present disclosure, a height of the cushioning structure is defined as $H_1$, and a height of the structural member is defined as $H_2$, satisfying: $0.5H_2 \leq H_1 \leq H_2$.

In an embodiment of the present disclosure, a direction from the non-structural area to the structural area is defined as a width direction, and a width of the cushioning structure is defined as D, satisfying: $0.1\mu m \leq 0 \leq 1000\mu m$.

In an embodiment of the present disclosure, the structural member is used to be imprinted to form a transferring structure for a flexible template, and when the imprinting master-template is transferred to form the transferring structure for the flexible template, the cushioning structure is used to be imprinted to form a supporting structure that supports the flexible template.

In addition, to solve the above problem, the present disclosure further provides a manufacturing method applied to the imprinting master-template as described above, the manufacturing method includes: providing a photoresist on a surface of the master-template, exposing the structural area of the master-template, and etching the exposed master-template to form the structural member; and

Providing a photoresist on the surface of the master-template where the structural member had been formed, exposing the non-structural area of the master-template, and etching the exposed master-template to form the cushioning structure.

In an embodiment of the present disclosure, after the step of forming the structural member, the method further comprises:

Removing the photoresist from the master-template by removing the photoresist on the surface of the master-template.

In the technical solution proposed by the present disclosure, the imprinting master-template is transferred to form a flexible template, and the structural member in the master-template is transferred to form a transferring structure in the flexible template. The transferring structure is used to transfer the structural member in the structural area to the substrate. The non-structural area of the master-template is provided with a cushioning structure. When the imprinting master-template is transferred to form the transferring structure of the flexible template, the cushioning structure is simultaneously transferred to form a supporting structure which is provided on the flexible template. When pattern transfer is performed through the flexible template, the supporting structure can support the flexible template to reduce the occurrence of voids. During imprinting with an imprinting glue material, the imprinting glue can flow along the supporting structure, reducing the occurrence of imprinting defects and improving the yield of nano-imprinting.

## BRIEF DESCRIPTION OF THE DRAWINGS

In order to clearly illustrate the technical solutions in the embodiments of the present disclosure or the prior art, the drawings required for describing the embodiments or the prior art will be briefly introduced below. It is obvious that the drawings described below are only a few embodiments of the present disclosure. For those skilled in the art, other drawings can be obtained based on the structures shown in these drawings without creative efforts.

FIG. 1 is a structural illustration of the related art during imprinting;
FIG. 2 is a structural illustration of a first embodiment of the imprinting master-template according to the present disclosure;
FIG. 3 is a structural illustration of a flexible template formed by the imprinting master-template in FIG. 2 according to the present disclosure;
FIG. 4 is a structural illustration of a second embodiment of an imprinting master-template according to the present disclosure;
FIG. 5 is a structural illustration of an embodiment of the imprinting master-template in a top view;
FIG. 6 is a structural illustration of another embodiment of the imprinting master-template according to the present disclosure in a top view;
FIG. 7 is a structural illustration of a second embodiment of an imprinting master-template according to the present disclosure;
FIG. 8 is a structural illustration of a third embodiment of an imprinting master-template according to the present disclosure;
FIG. 9 is a structural illustration of a fourth embodiment of an imprinting master-template according to the present disclosure;
FIG. 10 is a structural illustration of a fifth embodiment of an imprinting master-template according to the present disclosure;
FIG. 11 is a structural illustration of a sixth embodiment of an imprinting master-template according to the present disclosure;
FIG. 12 is a structural illustration of a seventh embodiment of an imprinting master-template according to the present disclosure;
FIG. 13 is a flowchart of a first embodiment of a method for manufacturing an imprinting master-template in accordance with the present disclosure;
FIG. 14 is a flowchart of a second embodiment of the method for manufacturing an imprinting master-template according to the present disclosure;
FIG. 15 is a schematic illustration of etching the structural area of the imprinting master-template in the present disclosure;
FIG. 16 is a schematic illustration of etching the non-structural area of the imprinting master-template in the present disclosure.

Reference Signs:

| Reference Sign | Name | Reference Sign | Name |
|---|---|---|---|
| 10 | Master-template | 1214 | Separator |

(continued)

| Reference Sign | Name | Reference Sign | Name |
|---|---|---|---|
| 110 | Structural area | 20 | Flexible template |
| 111 | Structural member | 210 | Transferring structure |
| 120 | Non- structural area | 220 | Supporting structure |
| 121 | Cushioning Structure | 30 | Photoresist |
| 1211 | Groove | 40 | Imprinting glue |
| 1212 | Cushioning member | 50 | Void |
| 1213 | Gradual cushioning member | | |

The implementation, functional characteristics, and advantages of the present disclosure will be further explained in conjunction with the embodiments, with reference to the accompanying drawings.

## DETAILED DESCRIPTION

The following will provide a clear and complete description of the technical solution in the embodiments of the present disclosure, in conjunction with the accompanying drawings. Obviously, the described embodiments are only a part of the embodiments of the present disclosure, rather than all of them. Based on the embodiments in the present disclosure, all other embodiments obtained by those of ordinary skill in the art without creative labor shall fall within the scope of protection of the present disclosure.

It is to be noted that all directional indications (such as up, down, left, right, front, back...) in the embodiments of the present disclosure are only used to explain the relative position relationship and motion situation between components in a specific posture (as shown in the figure). If the specific posture changes, the directional indication also changes accordingly.

Furthermore, in the present disclosure, descriptions related to "first", "second", etc. are only used for descriptive purposes and cannot be understood as indicating or implying their relative importance or implying the number of indicated technical features. Therefore, the features limited to "first" and "second" can explicitly or implicitly include at least one of these features. In the description of the present disclosure, "multiple" means at least two, such as two, three, etc., unless otherwise specified.

In the present disclosure, unless otherwise specified and limited, the terms "connection", "fixed", etc. should be broadly understood, for example, "fixed" can be a fixed connection, a detachable connection, or a whole; It can be a mechanical connection or an electrical connection; It can be directly connected, or indirectly connected through an intermediate medium; it can be the internal connection of two components or the interaction relationship between two components, unless otherwise specified. For those of ordinary skill in the art, the specific meanings of the above terms in the present disclosure can be understood based on specific circumstances.

In addition, the technical solutions of the various embodiments of the present disclosure can be combined with each other, but must be based on what ordinary technicians in the art can achieve. When the combination of technical solutions is contradictory or impossible to achieve, it should be considered that the combination of such technical solutions does not exist and is not within the scope of protection required by the present disclosure.

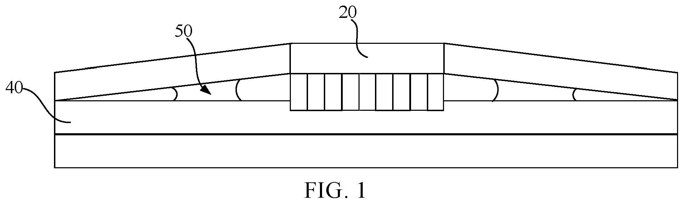

In the related art, the nanoimprinting process is a micro-nano processing technology that transfers patterns to substrates through a nanoimprinting glue 40, where the master-template is the foundation of the nanoimprinting process. However, the height of the non-structural area of the master-template is usually comparable to that of the structural area thereof. During a pattern transfer process using flexible materials, due to the softness of the flexible materials, the edges of the flexible materials will collapse towards the imprinting glue during transfer, forming a void 50 at the edge of the structural area. As shown in FIG. 1, the imprinting glue 40 cannot completely fill this void 50, resulting in a recessed nanoimprinting defect. This causes corresponding defects after curing of the nanoimprinting glue 40, which reduces the yield of nanoimprinting. There are many product structures using nanoimprinting technology. For example, in the field of display technology (such as LEDs, microlenses, wire grid polarizers, diffractive optical elements with uniform light or spot shaping functions, super-lenses, etc.), including AR (Augmented Reality) display fields (such as devices represented by binary gratings, two-dimensional gratings, blazed gratings, and tilted gratings), under-screen fingerprint fields (such as microlenses and collimation holes), gene sequencing fields (such as micro-nano array structures), etc., as well as VR (Virtual Reality).

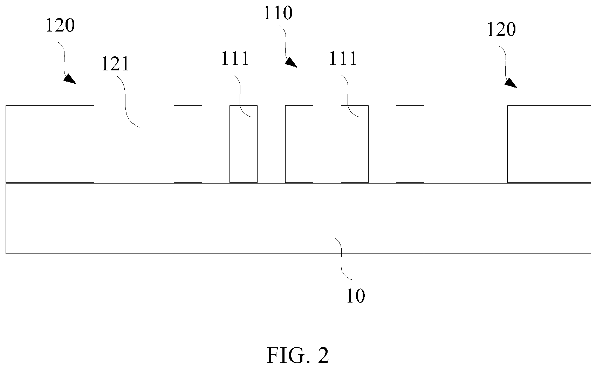

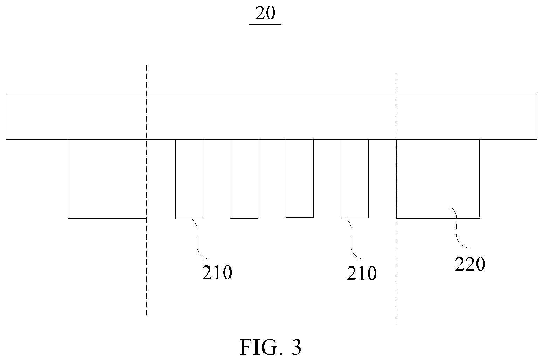

In order to solve the above problems, referring to FIG. 2 and FIG. 3, this embodiment proposes an imprinting master-template for transferring and forming a flexible template 20. The flexible template 20 is provided with a transferring structure 210, which is used to transfer and form the flexible template 20. In this embodiment, the flexible template 20 is used, and the texture of the flexible template 20 is soft, which will not cause hard contact with the imprinting master-template, thereby reducing damage to the imprinting master-template and improving its service life. Especially in the demolding process, the flexible template 20 particularly tends to bend and pry, and voids are more likely to occur between the flexible template 20 and the imprinting master-template, causing separation between the two much easier. The imprinting master-template includes a master-template 10 and a cushioning structure 121. The cushioning structure 121 is provided on the master-template 10, and a supporting structure 220 supporting the flexible template 20 is transferred through the cushioning structure 121. The flexible template 20 is supported by the supporting structure 220, thereby avoiding the occurrence of air voids on a lateral edge of the transferring structure 210 during nanoimprinting. The master-template 10 and the cushioning structure 121 can be separate independent structures or an integrated molding structure.

The surface of the master-template 10 is provided with a structural area 110 and a non-structural area 120. The non-structural area 120 is located on a lateral edge of the structural area 110, and the structural area 110 is provided with structural members 111, which are used to be imprinted and form the transferring structure 210 of the flexible template 20. The structural shape of the structural members 111 is the shape that the nanoimprinting glue needs to be processed. First, the structural members 111 are imprinted to form the transferring structure 210 of the flexible template 20, and then the shapes of the structural members 111 are obtained by transferring the transferring structure 210 through nanoimprinting glue. The material of the master-template 10 is a hard material, and the master-template 10 can be used repeatedly.

The cushioning structure 121 is provided in the non-structural area 120. When the imprinting master-template is transferred to form the transferring structure 210 of the flexible template 20, the cushioning structure 121 is used to be imprinted and form the supporting structure 220 that supports the flexible template 20. The supporting structure 220 can support the flexible template 20, reducing its collapse, thus leaving sufficient flow space for the nanoimprinting glue and avoiding the occurrence of voids.

It is to be noted that the imprinting master-template can be used for imprinting without using the flexible template 20, instead, by directly providing the imprinting glue on the surface of the imprinting template and then curing it.

In the technical solution proposed in this embodiment, the master-template is imprinted to form the flexible template 20 and the structural members 111 in the master-template 10 are transferred to form the transferring structure 210 in the flexible template 20. The transferring structure 210 is used to transfer the structural members 111 in the structural area 110 to the substrate. The non-structural area 120 of the master-template 10 is provided with a cushioning structure 121. When the imprinting master-template is transferred to form the transferring structure 210 of the flexible template 20, the cushioning structure 121 is simultaneously transferred to form a supporting structure 220, which is provided on the flexible template 20. When pattern transfer is performed using the flexible template 20, the supporting structure 220 can support the flexible template 20, reducing the occurrence of voids 50 on a lateral edge of the transferring structure 210. When imprinting with an imprinting glue 40, the imprinting glue 40 can flow along the supporting structure 220, thereby reducing imprinting defects and improving the yield of nanoimprinting.

In the above embodiment of the present application, in order to effectively complete provision of the supporting structure 220, the cushion structure 121 includes grooves 1211, which are arranged on opposite sides of the structural area 110. Therefore, the supporting structure 220 formed by imprinting with the grooves 1211 is a columnar structure, which completes the support to the edge portion of the flexible template 20. The columnar structure is simple and easy to process.

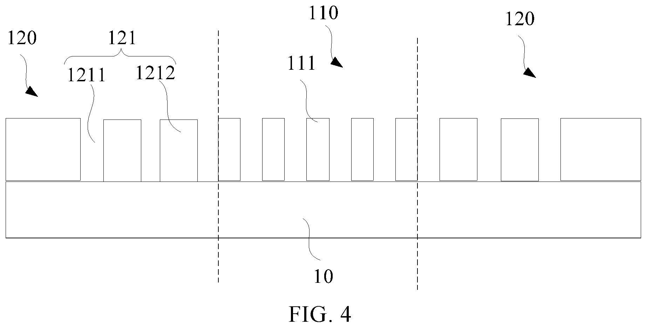

Furthermore, in order to protect the transferring structure 210 in the flexible template 20, referring to FIG. 4, the cushioning structure 121 also includes a plurality of cushioning members 1212, which are arranged spaced apart in the groove 1211. The arrangement of the cushioning members 1212 can disconnect the entire contact area and form multiple contact surfaces. When the flexible template 20 and the master-template 10 are separated, the separation between the flexible template 20 and the master-template 10 start from the edge. During demolding, the contact area is prevented from sudden increasing. Therefore, while reducing the occurrence of voids, it is also possible to avoid damage to the transferring structure 210. In addition, it is to be noted that during demolding, the transferring structure 210 can also be protected by the supporting structure 220, that is, by deformation and prying of the supporting structure 220, the flexible template 20 is separated from the imprinting master-template, thereby separating them. Even if the supporting structure 220 is damaged, the transferring structure 210 can be guaranteed to be intact.

Furthermore, in order to make the support force of the flexible template 20 more stable, the spacings between the plurality of cushioning members 1212 are equal. Due to the equal spacing between the cushioning members 1212, the resulting supporting structure 220 is also a plurality of equally spaced supporting members. Through the equally spaced support members, the force acting on the flexible template 20 is more stable.

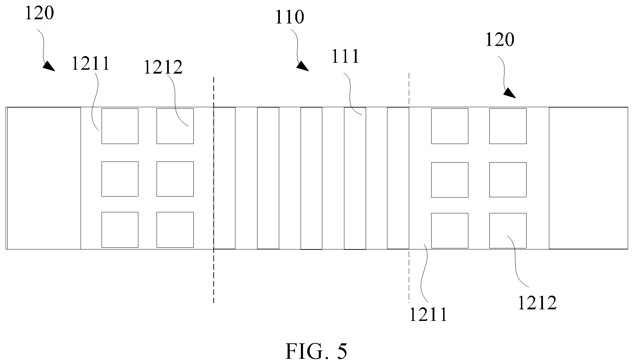

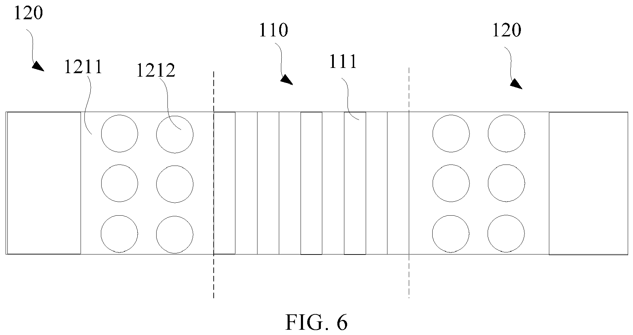

In addition, it is to be noted that the arrangement of the cushioning members 1212 also includes various ways. The cushioning members are periodically distributed in the groove 1211. The periodic distribution of the cushioning members may include two-dimensional periodic structures and three-dimensional periodic structures. In a two-dimensional periodic structure, the structure of the cushioning members 1212 is arranged in one direction and extends in the other direction, for example, distributed in the length direction and extending in the width direction. When the cushioning members 1212 is a three-dimensional periodic structure, the structure of the cushioning members 1212 is arranged in one direction and multiple cushioning members 1212 are also arranged in the other direction. For example, the cushioning members 1212 is distributed in the length direction and also distributed in the width direction. Referring to Figure 5 and Figure 6, in a top view of the imprinting master-template in this embodiment, the three-dimensional arrangement of the cushioning members 1212 can be seen, where the cross-section of the cushioning members 1212 can be square or circular. The cross-section can also be understood as the bottom surface of the cushioning members 1212. Of course, the cross-section of the cushioning members 1212 can also be other shapes, such as triangular or other polygons.

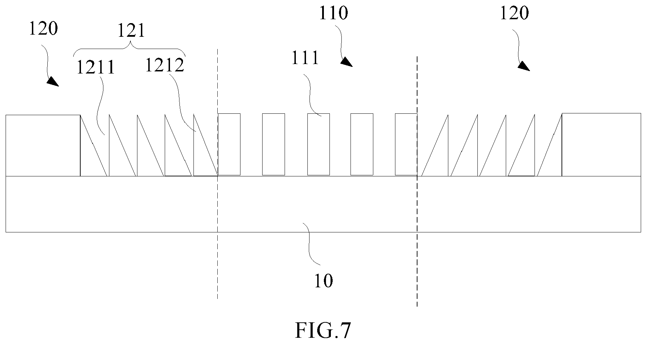

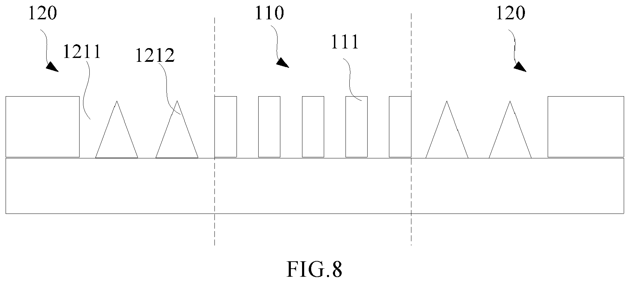

It is to be noted that, referring to Figure 7, the shape of the cushioning members 1212 is triangular, with one base of the triangle touching the bottom surface of the groove 1211. A further triangle is a right-angled triangle, with one right-angled side thereof touching the bottom surface of the groove., and the hypotenuse thereof facing towards the lateral edge of the structural area 110. Referring to Figure 8, the cushioning members 1212 can also be an isosceles triangle, with the base of the isosceles triangle touching the bottom surface of the groove 1211. It should be further noted that the triangles are also spaced apart from each other.

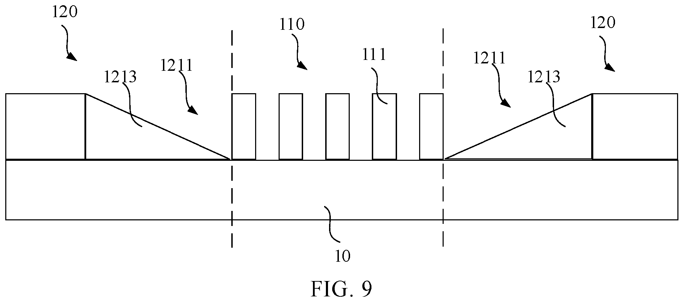

Referring to Figure 9, in another embodiment of the present application, the closer the position is to the transferring structure 210, the larger the potential air void may occur. In order to support the corresponding position, a direction from the groove bottom surface of the groove 1211 to the mouth of the groove 1211 is defined as a height direction, the cushioning structure includes gradual cushioning members 1213 provided at the groove bottom of the groove 1211, the heights of the gradual cushioning members 1213 decrease from the non-structural area 120 to the structural area 110. For example, the heights of the gradual cushioning members 1213 gradually decrease, and the upper surfaces of the gradual cushioning members 1213 and the groove bottom of the groove 1211 form an inclined slope. The height of the resulting supporting structure 220 increases gradually from the non-structural area 120 to the structural area 110. Generally, there is a large height difference near the transferring structure 210 on the flexible template 20, and it is easier for air voids to occur at the position of the transferring structure 210. The gradual cushioning members 1213 increase in height differences therebetween near the structural area 110, becoming higher near the structural area 110; this also reduces the height differences at the lateral edge of the transferring structure. A supporting structure 220 is formed at the lateral edge of the transferring structure 210, via which supporting structure the height differences are alleviated. At the same time, nanoimprinting glue can flow along the supporting structure 220 and fill into the lateral edge corners of the transferring structure 210, which effectively accomplishes support for air voids and reduces potential air voids near the transferring structure 210.

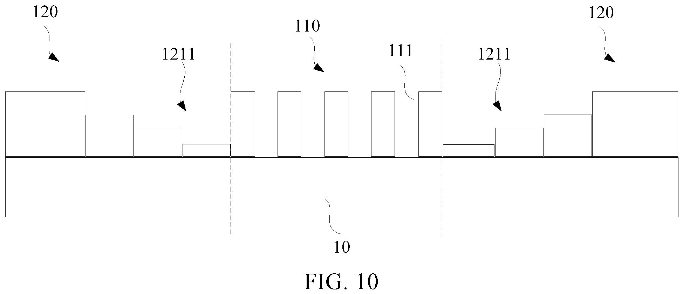

Further, referring to Figure 10, the height of the gradual cushioning members 1213 decrease in a stepped manner. The resulting supporting structure 220 increases in height from the non-structural area 120 to the structural area 110. Alternatively, a combination of a stepped structure and a sloped inclination may be used, such as a section of slope followed by a section of steps.

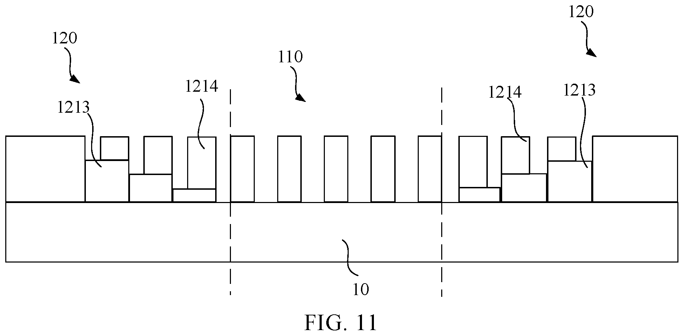

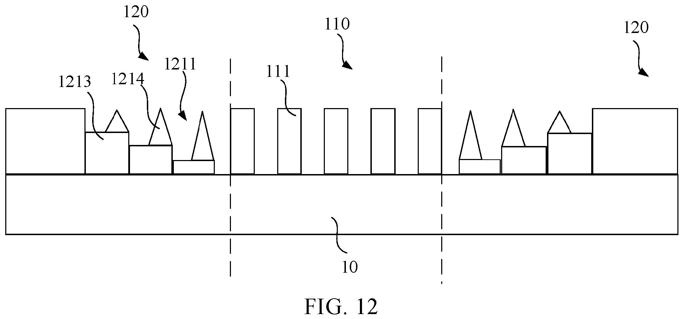

Further, referring to Figure 11, the cushioning structure also includes a plurality of separators 1214, which are arranged spaced apart on the surface of the gradual cushioning members 1213. Similarly, the separators 1214 and the gradual cushioning members 1213 also include two-dimensional periodic structures and three-dimensional periodic structures. In the two-dimensional periodic structures, the separators 1214 are arranged in one direction and extend in another direction. For example, they are distributed in the length direction and extend in the width direction. When the separators 1214 are three-dimensional periodic structures, they are arranged in one direction and a plurality of separators 1214 are also arranged in another direction. For example, the separators 1214 are distributed in the length direction and width direction to form a matrix distribution structure. The cross section of the separators 1214 can be square or circular. Of course, the cross section of the separators 1214 can also be other shapes, as shown in Figure 12, such as triangular or other polygonal shapes.

In one embodiment of the present application, the cushioning structure is used to be transferred and form a supporting structure that supports the flexible template. The height of the cushioning structure can be low or high. It can play a cushioning role within a certain range of height differences. The height of the cushioning structure is defined as $H_1$, and the height of the structural members is defined as $H_2$, satisfying: $0.5H_2 \leq H_1 \leq H_2$. For example, the height of the cushioning structure is only half of the height of the structural member. If the cushioning structures are lower than this height, it will be difficult to play a cushioning and supporting role. The height of the cushioning structures can also be equal to the height of the structural member. If the cushioning structures are higher than this height, the cushioning structures will be more protruding, which will form an air void in the structural area during the manufacture of the flexible template, leaving nanoimprinting defects. Therefore, after the heights of the cushioning structure and structural member satisfy the above relationship, it can ensure smooth completion of nanoimprinting, avoid forming poor imprinting, and improve imprinting yield.

In an embodiment of the present application, in order to smoothly complete the nano-scale imprinting work through the imprinting master-template, and ensure that the cushioning structures can play a role in increasing the circulation of nano-imprinting glue, defining the direction from the non-structural area to the structural area as the width direction, and defining the width of the cushioning structure as D, then satisfying $0.1\mu m \leq D \leq 1000\mu m$. If the width of the cushioning structures is greater than $0.1\mu m$, this requires a lower processing accuracy, which is sufficient to ensure that the cushioning structures can complete the cushioning support. If the width of the cushioning structures is greater than $1000\mu m$, then the width is wider, which increases processing time, generates waste, and reduces production efficiency. Therefore, the width of the cushioning structure is between $0.1\mu m$ and $1000\mu m$, which can meet the imprinting requirements without making the processing time too long.

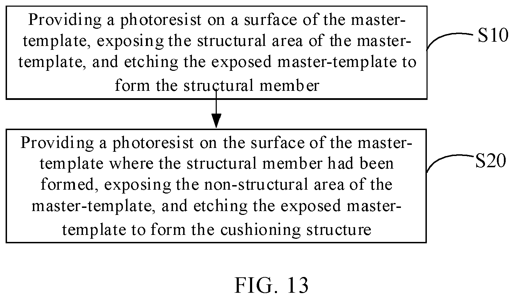

The present disclosure also provides a manufacturing method using the imprinting master-template as described above. Referring to FIG. 13, the manufacturing method includes:

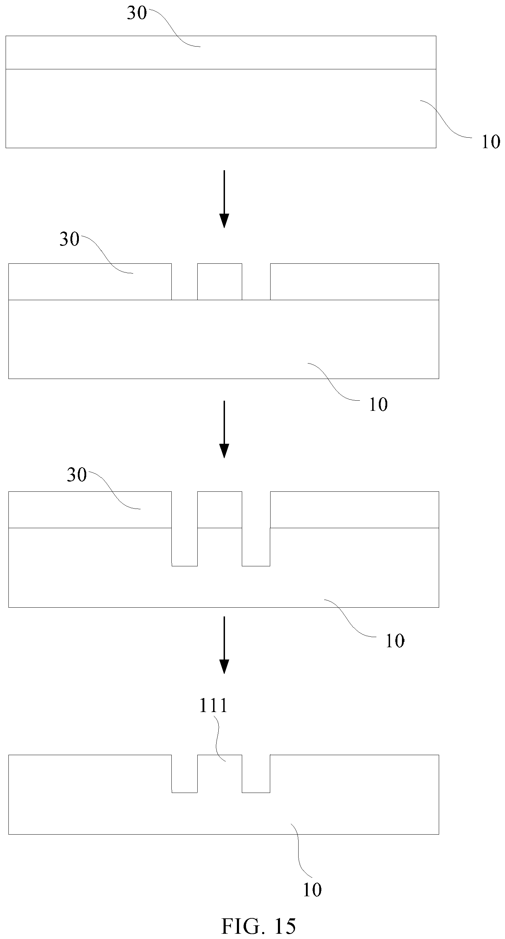

Step S10, providing a photoresist on a surface of the master-template, exposing the structural area of the master-template, and etching the exposed master-template to form the structural member; wherein, the material of the master-template can be silicon or quartz as the substrate. Referring to FIG. 15, step S10 mainly accomplishes the manufacture of the structural area of the master-template. Photoresist 30 is provided on one of the surfaces of the master-template by coating. The type of photoresist can be determined according to the size of the area to be etched. If the area to be etched is small, a positive photoresist can be selected. Conversely, if the area to be etched is large, a negative photoresist or a pattern reversal photoresist can be selected. The structural area is exposed using electron beam exposure, dual beam exposure, laser direct writing, deep ultraviolet lithography, Taber effect, etc. After exposure, traditional development techniques are required. After development, for the pattern of the structural area, etching methods such as IBE (ion beam etching), RIE reactive ion etching, RIBE (reactive ion beam etching), ICP (plasma etching), etc. can be used to form a cushioning structure.

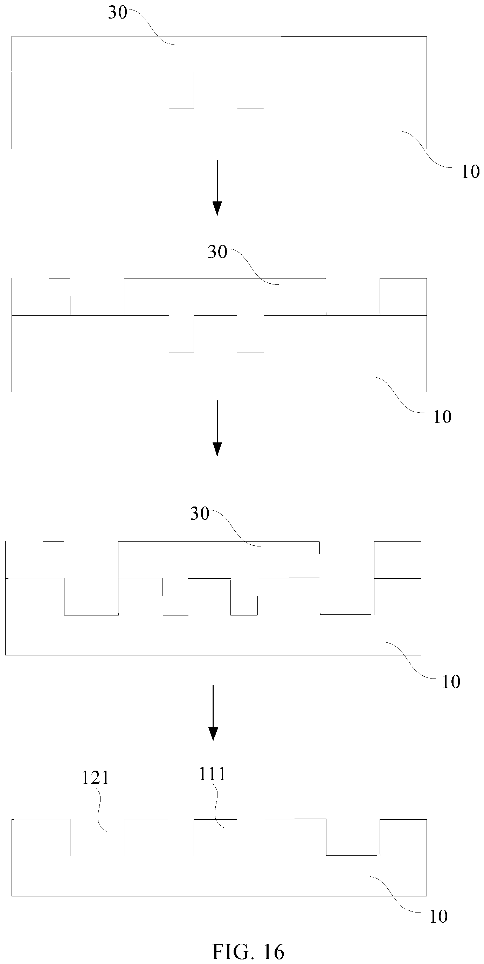

Step S20, providing a photoresist on the surface of the master-template where the structural member had been formed, exposing the non-structural area of the master-template, and etching the exposed master-template to form the cushioning structure. Referring to FIG. 16, step S20 mainly accomplishes the provision of the cushioning structure in the master-template. Similarly, a photoresist is applied to the surface of the master-template. The type of photoresist can be determined based on the size of the area to be etched. If the area to be etched is small, a positive photoresist can be selected. Conversely, if the area to be etched is large, a negative photoresist or a pattern reversal photoresist can be selected. The non-structural area is exposed using electron beam exposure, dual beam exposure, laser direct writing, deep ultraviolet lithography, and Taber effect. After exposure, traditional development techniques are required. After development, for the pattern of the structural area, etching methods such as IBE (ion beam etching), RIE (reactive ion etching), RIBE (reactive ion beam etching), and ICP (plasma etching) can be used to form a cushioning structure.

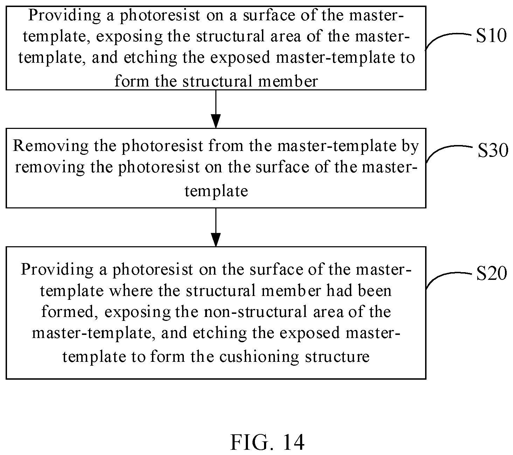

In an embodiment of the present application, referring to FIG. 14, after the step of forming a structural member, it includes:

Step S30, removing the photoresist from the master-template by removing the photoresist on the surface of the master-template. During the formation of a structural member, photoresist can protect the surface of the master-template. After etching, remove the photoresist by soaking it in stripping solution to facilitate re-coating to protect the structural member of the processed structural area. During the removal process, ultrasonic assistance can also be added to accelerate the removal of photoresist. Similarly, after completing the etching operation of the cushioning structure, the photoresist is also to be removed to ensure that the surface of the master-template is clean for subsequent imprinting operations.

The above is only a preferred embodiment of the present disclosure, and does not limit the scope of the disclosure. Any equivalent structural transformation made using the content of the description and drawings of the present disclosure, or direct/indirect application thereof in other related technical fields, shall be included within the scope of protection of the present disclosure.

**Claims**

1. An imprinting master-template, **characterized in that** the imprinting master-template comprises:

a master-template, a surface of which being provided with a structural area and a non-structural area, the non-structural area being provided on a lateral edge of the structural area, and the structural area being provided with a structural member; and

a cushioning structure, provided in the non-structural area.

2. The imprinting master-template according to claim 1, **characterized in that** the cushioning structure comprises grooves provided on two opposite sides of the structural area.

3. The imprinting master-template according to claim 2, **characterized in that** the cushioning structure further comprises a plurality of cushioning members arranged spaced apart in the grooves.

4. The imprinting master-template according to claim 3, **characterized in that** the plurality of cushioning members are in periodical distribution in the grooves.

5. The imprinting master-template according to claim 2, **characterized in that** a direction from a bottom surface of a groove to a mouth of the groove is defined as a height direction, and the cushioning structure comprises gradual cushioning members whose height decrease from the non-structural area to the structural area.

6. The imprinting master-template according to claim 5, **characterized in that** the cushioning structure further comprises a plurality of separators arranged spaced apart on a surface of the gradual cushioning members.

7. The imprinting master-template according to claim 6, **characterized in that** the separators are in periodical distribution in the grooves.

8. The imprinting master-template according to claim 4, **characterized in that** periodic distribution of the cushioning members comprises extension in a length direction thereof and spaced-apart arrangement in both the length direction and a width direction thereof.

9. The imprinting master-template according to any one of claims 1 to 7, **characterized in that** a height of the cushioning structure is defined as $H_1$, and a height of the structural member is defined as $H_2$, satisfying: $0.5H_2 \leq H_1 \leq H_2$.

10. The imprinting master-template according to any one of claims 1 to 7, wherein a direction from the non-structural area to the structural area is defined as a width direction, and a width of the cushioning structure is defined as D, satisfying:

$$0.1\mu m \leq D \leq 1000\mu m.$$

11. The imprinting master-template according to any one of claims 1 to 7, **characterized in that** the structural member is used to be imprinted to form a transferring structure for a flexible template, and
when the imprinting master-template is transferred to form the transferring structure for the flexible template, the cushioning structure is used to be imprinted to form a supporting structure that supports the flexible template.

12. A manufacturing method, **characterized in that** the manufacturing method uses the imprinting master-template according to any one of claims 1 to 11, and the manufacturing method comprises:

providing a photoresist on a surface of the master-template, exposing the structural area of the master-template, and etching the exposed master-template to form the structural member; and
providing a photoresist on the surface of the master-template where the structural member had been formed, exposing the non-structural area of the master-template, and etching the exposed master-template to form the cushioning structure.

13. The manufacturing method according to claim 12, **characterized in that** after the step of forming the structural member, the method further comprises:
removing the photoresist from the master-template by removing the photoresist on the surface of the master-template.

FIG. 1

120    121    111    110    111    120

FIG. 2

FIG. 3

FIG. 4

FIG. 5

120

1211     1212

110     111

120

FIG. 6

FIG.7

120

1211    1212    110    111    120

FIG.8

FIG. 9

FIG. 10

FIG. 11

120

110

120

1213 1214 1211 111

FIG. 12

10

Providing a photoresist on a surface of the master-template, exposing the structural area of the master-template, and etching the exposed master-template to form the structural member ⟶ S10

Providing a photoresist on the surface of the master-template where the structural member had been formed, exposing the non-structural area of the master-template, and etching the exposed master-template to form the cushioning structure ⟶ S20

FIG. 13

Providing a photoresist on a surface of the master-template, exposing the structural area of the master-template, and etching the exposed master-template to form the structural member ⟋ S10

Removing the photoresist from the master-template by removing the photoresist on the surface of the master-template ⟋ S30

Providing a photoresist on the surface of the master-template where the structural member had been formed, exposing the non-structural area of the master-template, and etching the exposed master-template to form the cushioning structure ⟋ S20

FIG. 14

30

10

30

10

30

10

111

10

FIG. 15

30

10

30

10

30

10

121    111

10

FIG. 16

## INTERNATIONAL SEARCH REPORT

| International application No. |
| --- |
| **PCT/CN2022/113515** |

### A. CLASSIFICATION OF SUBJECT MATTER

G03F 7/00(2006.01)i

According to International Patent Classification (IPC) or to both national classification and IPC

### B. FIELDS SEARCHED

Minimum documentation searched (classification system followed by classification symbols)

G03F

Documentation searched other than minimum documentation to the extent that such documents are included in the fields searched

Electronic data base consulted during the international search (name of data base and, where practicable, search terms used)

CNABS; CNTXT; CNKI; VEN; USTXT; EPTXT; WOTXT: 歌尔光学科技有限公司, 母板, 模板, 功能区, 结构区, 非结构区, 缓冲区, 凹陷, 凹槽, 刻蚀, 光刻胶, 曝光, substrate, cut+, area, template, plate+

### C. DOCUMENTS CONSIDERED TO BE RELEVANT

| Category* | Citation of document, with indication, where appropriate, of the relevant passages | Relevant to claim No. |
| --- | --- | --- |
| Y | CN 105097670 A (BOE TECHNOLOGY GROUP CO., LTD. et al.) 25 November 2015 (2015-11-25)<br>  description, paragraphs [0002]-[0076], and figures 1-10 | 1-13 |
| Y | CN 112305859 A (NATIONAL CENTER FOR NANOSCIENCE AND TECHNOLOGY) 02 February 2021 (2021-02-02)<br>  description, paragraphs [0009]-[0126], and figures 1-9 | 1-13 |
| A | CN 112689797 A (APPLIED MATERIALS INC.) 20 April 2021 (2021-04-20)<br>  entire document | 1-13 |
| A | JP H1158401 A (SEIKO EPSON CORP.) 02 March 1999 (1999-03-02)<br>  entire document | 1-13 |
| A | CN 111650771 A (BOE TECHNOLOGY GROUP CO., LTD.) 11 September 2020 (2020-09-11)<br>  entire document | 1-13 |

☐ Further documents are listed in the continuation of Box C.    ☑ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **24 October 2022** | **09 November 2022** |

| Name and mailing address of the ISA/CN | Authorized officer |
| --- | --- |
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

INTERNATIONAL SEARCH REPORT
Information on patent family members

International application No.

**PCT/CN2022/113515**

| Patent document cited in search report | | | Publication date (day/month/year) | Patent family member(s) | | | Publication date (day/month/year) |
|---|---|---|---|---|---|---|---|
| CN | 105097670 | A | 25 November 2015 | US | 2017192294 | A1 | 06 July 2017 |
| | | | | WO | 2017020579 | A1 | 09 February 2017 |
| | | | | CN | 105097670 | B | 09 March 2018 |
| | | | | US | 10459271 | B2 | 29 October 2019 |
| CN | 112305859 | A | 02 February 2021 | CN | 112305859 | B | 12 July 2022 |
| CN | 112689797 | A | 20 April 2021 | WO | 2020052750 | A1 | 19 March 2020 |
| | | | | TW | 202024784 | A | 01 July 2020 |
| | | | | KR | 20210049170 | A | 04 May 2021 |
| | | | | EP | 3850433 | A1 | 21 July 2021 |
| | | | | US | 2021341834 | A1 | 04 November 2021 |
| | | | | JP | 2022500857 | A | 04 January 2022 |
| JP | H1158401 | A | 02 March 1999 | JP | 3577903 | B2 | 20 October 2004 |
| CN | 111650771 | A | 11 September 2020 | None | | | |

Form PCT/ISA/210 (patent family annex) (January 2015)